# FASCICULE DE BREVET EUROPEEN

(11) **EP 3 790 063 B1**
(45) Date de publication et mention de la délivrance du brevet: **02.12.2026**
(21) Numéro de dépôt: 20201521.0
(22) Date de dépôt: 16.10.2014
(51) Int. Cl.: H10N 30/30, B82B 3/00, H10P 95/00, H10P 95/90

(54) **CAPTEUR SENSIBLE À LA PRESSION PAR DÉFORMATION D'UNE COUCHE PIÉZOÉLECTRIQUE RIDÉE**
SENSOR, DER AUF DRUCK DURCH VERFORMUNG EINER GEFURCHTEN PIEZOELEKTRISCHEN SCHICHT REAGIERT
SENSOR SENSITIVE TO PRESSURE BY DEFORMATION OF A RIPPLED PIEZOELECTRIC LAYER

(30) Priorité: 17.10.2013 FR 1360110
(43) Date de publication de la demande: 10.03.2021
(62) Numéro(s) de document de la (des) demande(s) initiale(s) en application de l'article 76 CBE: 14786853.3 / 3 058 602
(73) Titulaire: Commissariat à l'Energie Atomique et aux Energies Alternatives, 75015 Paris (FR)
(72) Inventeur: BENAISSA, Lamine, 38054 Grenoble Cedex 09 (FR); MOULET, Jean-Sébastien, 38054 Grenoble Cedex 09 (FR)
(74) Mandataire: Santarelli

(56) Documents cités:
- JP-A- 2003 134 594
- TW-A- 201 044 656
- US-A1- 2004 056 567
- MATTHES B ET AL: "Investigation of thin AIN films for piezolayer-field effect transistor applications", THIN SOLID FILMS, ELSEVIER, AMSTERDAM, NL, vol. 226, no. 1, 15 April 1993 (1993-04-15), pages 178 - 184, XP025731798, ISSN: 0040-6090, [retrieved on 19930415], DOI: 10.1016/0040-6090(93)90226-F

## Description

### DOMAINE TECHNIQUE

Le domaine de l'invention est celui des capteurs sensibles à la pression permettant par exemple de détecter un contact, une pression ou encore un mouvement de glissement. De tels capteurs trouvent notamment application dans le domaine de la robotique où ils peuvent équiper les outils de préhension des robots afin de réaliser une surveillance de la tenue d'objets.

### ÉTAT DE LA TECHNIQUE ANTÉRIEURE

Des capteurs sensibles à la pression, connus sous l'acronyme POSFET (*Piezoelectric Oxide Semiconductor Field Effet Transistor*)*,* fonctionnent sur le même principe qu'un transistor à effet de champ. Une couche piézoélectrique, le plus souvent en un polymère, typiquement du PVDF (polyfluorure de vinylidène), recouvre la région de grille d'un transistor MOS. Le champ interne de la couche piézoélectrique varie avec la pression qu'on lui applique, ce qui vient modifier le fonctionnement du transistor.

On connaît des documents TW 201 044 656 A et JP 2003 134594 A des capteurs acoustiques comprenant une couche piézoélectrique ondulée. Une telle couche piézoélectrique ondulée est utilisée dans un capteur de pression comme cela est décrit dans le document US 2004/056567 A1.

Le document Matthes B et AIL: "Investigation of thin AIN films for piezolayer-field effect transistor applications",THIN SOLID FILMS, ELSEVIER, AMSTERDAM, NL, vol. 226, no. 1, 15 avril 1993 (1993-04-15), pages 178-184, décrit un capteur de pression piézoélectrique AIN.

### EXPOSÉ DE L'INVENTION

L'invention a pour objectif d'améliorer la sensibilité des capteurs de pression exploitant la déformation de matériaux piézoélectriques. Elle propose pour ce faire un capteur sensible à la pression conforme à la revendication 1 et un ensemble de capteurs conforme à la revendication 9.

Certains aspects préférés mais non limitatifs de ce capteur et de cet ensemble sont définis dans les revendications dépendantes 2 à 8, et 10.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
- les figures 1a, 1b et 1c illustrent un procédé de structuration de surface pouvant être utilisé pour former des rides dans le cadre de la fabrication du capteur ;
- les figures 2a-2d illustrent un premier mode de réalisation possible du procédé de structuration de surface ;
- la figure 3 représente les rides formées en surface d'un substrat ;
- les figures 4a-4c illustrent un second mode de réalisation possible du procédé de structuration de surface ;
- les figures 5a-5b illustrent la création d'un bas-relief pour orienter les rides formées en surface d'un substrat ;
- les figures 6a-6e illustrent une variante de réalisation du second mode de réalisation possible du procédé de structuration de surface ;
- la figure 7 représente les rides formées en surface d'un substrat dans le cadre de la variante illustrée par les figures 6a-6e ;
- les figures 8 à 14 sont des schémas illustrant différentes variantes de réalisation d'un capteur, la figure 12 illustrant un capteur selon l'invention ;
- la figure 15 présente trois schémas d'agencement des électrodes vis-à-vis de la couche piézoélectrique.

### EXPOSÉ DÉTAILLÉ DE MODES DE RÉALISATION PARTICULIERS

L'invention porte sur un capteur sensible à la pression utilisant la déformation d'une couche piézoélectrique. Le capteur comprend un substrat supportant une couche piézoélectrique en un matériau piézoélectrique. La couche piézoélectrique présente des ondulations de surface sous la forme de rides sur lesquelles la pression est exercée lors de l'utilisation du capteur. La capacité de déformation d'une telle couche ridée est plus importante que celle d'une couche planaire. Il en découle une plus grande sensibilité à la pression. Le fait de disposer d'une couche ridée à l'image des empreintes digitales, et non d'une couche planaire, autorise en outre une détection d'un mouvement de glissement et selon les cas, de l'orientation de ce glissement.

La couche piézoélectrique est composée d'un matériau ayant des propriétés piézoélectriques. Elle est en un matériau solide qui peut être déposé ou reporté. Selon l'invention la couche piézoélectrique est en un matériau solide choisi parmi l'AlN, le PZT, le ZnO, Le LiNbO3, le LiTaO3, le KNbO3, le quartz, le SrTiO3, le BaTiO3, les langasites.

Le capteur comporte en plus de la couche piézoélectrique sous forme ridée au moins une électrode en un matériau conducteur de chaque côté du matériau piézoélectrique, par exemple de manière à former un sandwich électrode-couche piézoélectrique-électrode. Cet agencement assure la collection des charges générées par l'effet piézoélectrique lors de la déformation de la couche piézoélectrique.

L'empilement électrode - matériau piézoélectrique - électrode est supporté par le substrat pour permettre sa manipulation. Le substrat peut être composé de différentes couches solides et/ou polymères. Le capteur peut en outre comprendre des couches supplémentaires intermédiaires aux différents étages de l'empilement, par exemple pour en faciliter la fabrication, l'isolation, etc.

Les ondulations de surface de la couche piézoélectrique sont obtenues au moyen d'une technique basée sur des processus thermodynamiques d'auto-organisation.

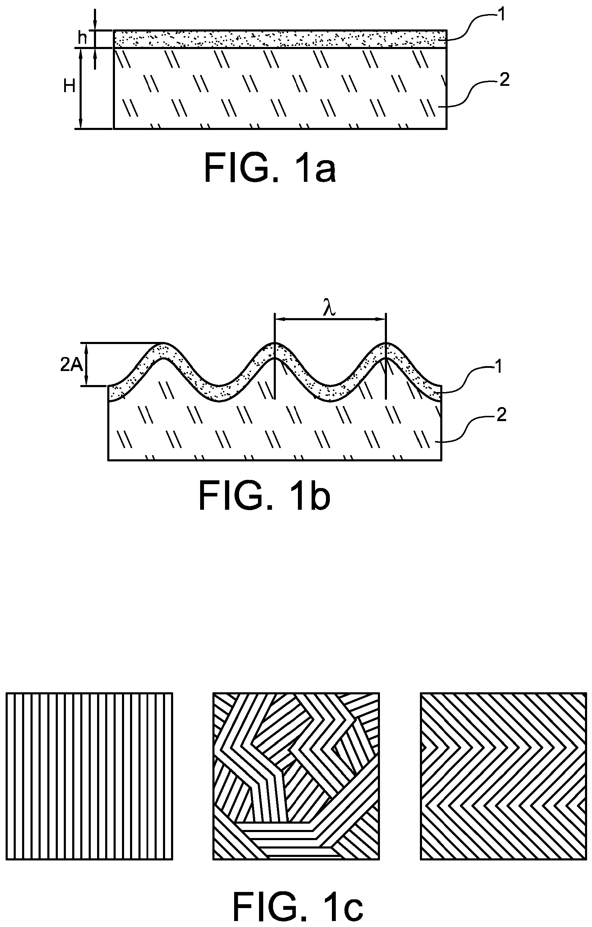

Cette technique, illustrée par les figures 1a-1c, repose sur la déformation d'une couche mince élastique 1 d'épaisseur h attachée à un support plus épais 2, d'épaisseur H. La couche mince élastique 1 est désignée par la suite par le terme de peau, et le support 2 par le terme de fondation. Cette déformation a pour moteur une contrainte qui relativement à la couche élastique correspond à un effort de compression de la fondation sur la couche. Cette contrainte introduit une instabilité du système couche élastique/fondation et conduit à la formation de rides caractérisées, comme représenté sur la figure 1b, par leur longueur d'onde λ et leur amplitude A (correspondant à la moitié de la hauteur crête à crête 2A). Comme représenté sur la figure 1c, les rides sont également caractérisées par leur orientation O qui peut prendre la forme de bandes (à gauche), de labyrinthes (au centre) ou de chevrons (à droite).

La théorie des rides décrit deux modes suivant lesquels le système couche élastique/fondation va gérer cette instabilité.

Lorsqu'à la fois la couche mince 1 et la fondation 2 sont élastiques, le système évolue spontanément pour minimiser son énergie. Dans ce contexte, l'émergence de rides d'une longueur d'onde donnée correspond à un compromis entre l'énergie de flexion du système et l'énergie nécessaire pour déformer la surface de la fondation. La formation des rides est au premier ordre dictée par le rapport des modules élastiques entre la peau et la fondation, leur rapport en épaisseurs et l'intensité de la contrainte à relaxer par le système. Plus la raideur de la fondation est faible, plus la contrainte critique nécessaire à la formation des rides est faible.

Sur le plan pratique, il faut donc des matériaux aux propriétés exceptionnelles (élastique et raideur faible) tels que les élastomères pour observer des rides. Une couche mince fortement contrainte sur une fondation rigide aura en effet tendance à produire une flèche plutôt que des rides.

Il est par ailleurs à noter qu'une fois les rides formées, le système est à l'équilibre. Le retrait de la couche mince provoque dès lors un retour spontané de la fondation élastique à son état initial, à savoir sans rides.

Lorsque la fondation est visqueuse, la formation des rides est provoquée pour des contraintes beaucoup plus faibles et l'énergie du système est principalement dissipée par écoulement visqueux de la fondation. Contrairement au système élastique/élastique, l'amplitude des rides est dans ce cas de figure assujettie à une cinétique qui est gouvernée par le module de relaxation de la fondation visqueuse. L'amplitude des rides est de ce fait limitée, et en pratique incompatible avec les applications visées.

Sur le plan pratique, la compréhension du système élastique/visqueux a permis l'élaboration de stratégies permettant la suppression des rides de faible amplitude. Par exemple en transférant des films contraints sur des fondations ad hoc, il est possible d'inverser le processus de formation des rides. Cela permet par exemple pour des films monocristallins d'autoriser une relaxation par expansion latérale plutôt que par la formation de dislocations.

Il existe pour ce deuxième mode un cas particulier qui correspond à la condition limite d'une fondation liquide. Un film mince contraint déposé sur un liquide forme en effet systématiquement des rides en surface compte tenu du faible module de relaxation du liquide. La manipulation d'un tel système (couche mince sur liquide) est toutefois sensible, ce qui limite à ce jour les applications aux études en laboratoire et/ou à la caractérisation de films minces.

Pour ces différents modes de relaxation, ils existent des solutions analytiques ou semi-analytiques qui permettent de décrire précisément la longueur d'onde et l'amplitude des rides formées. En ce qui concerne l'orientation, de nombreuses études rapportent que des ruptures de contrainte dans le plan sont à l'origine d'orientations privilégiées. Ainsi la création d'un bas-relief et ou bien la définition de motifs permettent d'orienter précisément les rides suivant la distribution du champ de contrainte dans le plan.

Il ressort de ce qui précède que les procédés de structuration de surface par formation de rides sont aujourd'hui essentiellement cantonnés à certains types de polymères, alors que pour les autres matériaux, la faible amplitude des rides obtenues (typiquement de l'ordre de 10 nm, soit inférieure à 20 nm crête à crête) reste incompatible avec les applications visées ou complexe à mettre en œuvre pour une production à grande échelle.

Ainsi, dans un premier mode de fabrication du capteur, on a recours à des polymères pour l'obtention des rides. Différentes techniques ont été développées au cours des vingt dernières années. On peut notamment citer les techniques mettant en œuvre un recuit du polymère suivi d'un dépôt de la couche mince, celles mettant en œuvre un étirement du polymère suivi d'un dépôt de la couche mince, celles reposant sur des procédés osmotiques, sur des traitements UV ou plasma, etc. Ce mode de fabrication sera désigné par le terme de « fabrication polymère » par la suite.

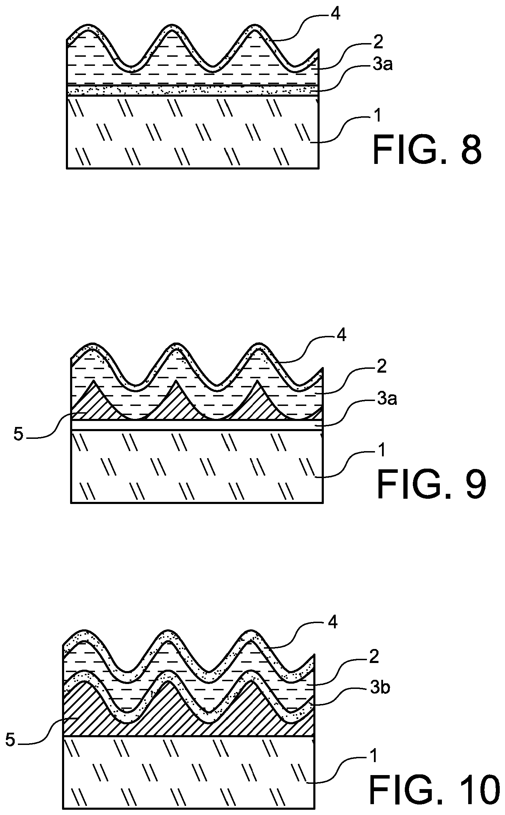

La couche polymère peut se situer à différents étages de l'empilement. Elle peut former une électrode (utilisation d'un polymère conducteur) et/ou la couche piézoélectrique (utilisation d'un polymère piézoélectrique tel que le PVDF). Le capteur peut présenter plusieurs couches polymères, et le substrat lui-même peut être en un matériau polymère. Le polymère peut également être une couche intermédiaire se situant dans l'empilement, au-dessus du substrat. Différents exemples de réalisation seront présentés par la suite en liaison avec les figures 8-10 et 13.

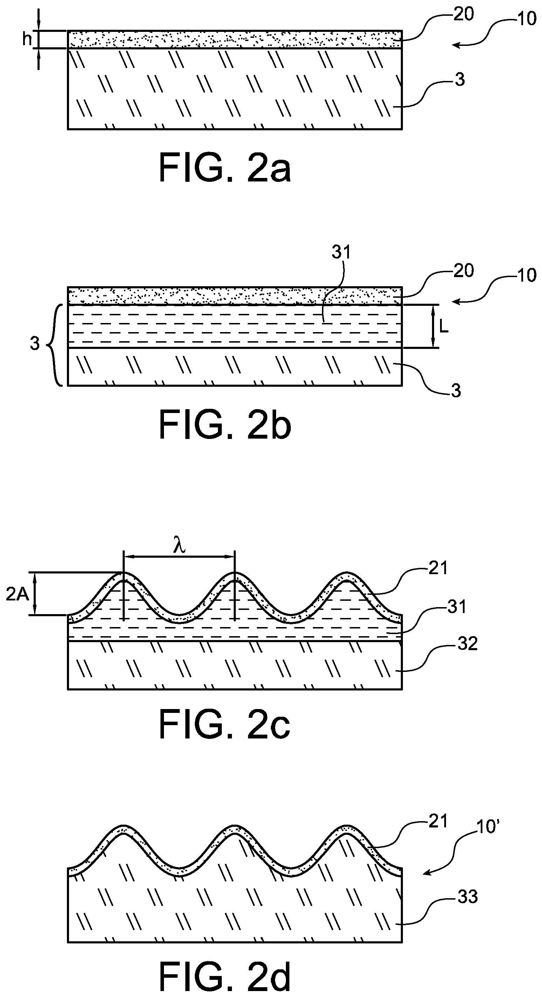

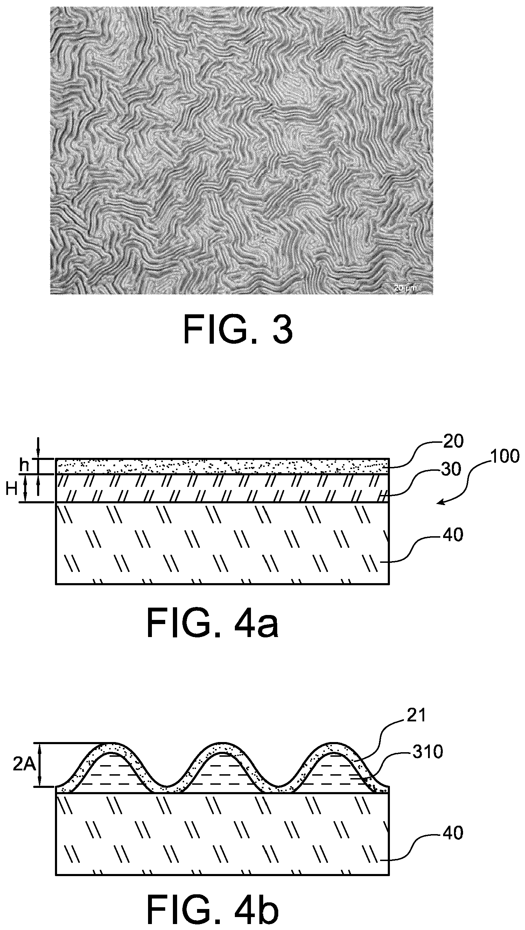

Un second mode de fabrication du capteur n'utilise pas de polymères pour l'obtention des rides mais suit le procédé de structuration de surface exposée aux figures 2a-2d et 4a-4c et qui met en œuvre un ou plusieurs cycles de fusion/solidification de la fondation. Ce mode de fabrication sera désigné par le terme de « fabrication solide » par la suite. On va ici décrire une première réalisation de rides à l'aide d'un empilement oxyde/silicium/oxyde, l'empilement ridé obtenu pouvant servir ensuite pour la réalisation d'un empilement comprenant une couche piézoélectrique en sandwich entre deux électrodes. En variante, le procédé décrit en lien avec cet empilement oxyde/silicium/oxyde peut être adapté pour obtenir des rides directement sur un empilement comportant une ou plusieurs électrodes et/ou une couche piézoélectrique.

En référence aux figures 2a et 4a, ce procédé vise à structurer la surface d'une structure bicouche 10, 100 comprenant initialement une couche contrainte 20 sur une fondation à l'état solide 3, 30. La couche contrainte 20 est plus particulièrement une couche élastique d'épaisseur h tandis que la fondation peut prendre la forme d'un substrat 3 comme représenté sur la figure 2a, ou d'une couche 30 d'épaisseur H formée en surface d'un substrat rigide 40 comme représenté sur la figure 4a.

La couche mince élastique contrainte 20 présente plus particulièrement une contrainte en tension dans au moins une direction du plan de la couche mince, ou bien une contrainte en compression uniquement dans une direction du plan.

La couche mince élastique 20 peut être formée par mise en œuvre d'un dépôt sur la fondation 3, 30, ou encore être formée par mise en œuvre d'une réaction chimique à la surface de la fondation (par exemple une oxydation, nitruration, carburation, etc.). La contrainte de la couche mince élastique est liée notamment au désaccord entre les paramètres de mailles des matériaux constituant la fondation et la couche mince, et peut être ajustée en jouant sur les conditions de formation de la couche mince, par exemple via la température du dépôt qui engendre une contrainte thermique plus ou moins importante selon la différence entre les coefficients de dilatation thermique de la couche mince et de la fondation.

En référence aux figures 2b et 4b, ce procédé de structuration de surface comprend une étape de fusion d'une partie au moins de la fondation pour l'amener à l'état liquide, ladite partie au moins étant au contact de la couche élastique contrainte.

Ladite partie au moins de la fondation amenée à l'état liquide présente une épaisseur L, et peut correspondre dans un premier mode de réalisation à une couche supérieure 30 d'une fondation sous la forme d'un substrat 3 au contact de la couche mince élastique (figure 2b) ou encore dans un second mode de réalisation à une partie ou à l'intégralité d'une fondation sous la forme d'une couche 30 d'épaisseur H en surface d'un substrat rigide 40 (figure 4b).

Comme illustré sur les figures 2c et 4b, ladite partie au moins désormais liquide 31, 310 découple mécaniquement la couche mince élastique contrainte 20 d'une partie solide constituée par la partie solide 32, non fusionnée, du substrat-fondation 3, ou encore constituée par le substrat rigide 40 sous la couche-fondation 30. Durant le temps de fusion, la structure bicouche 10, 100 se positionne dans la condition limite correspondant à une relaxation théorique couche mince élastique / fondation visqueuse avec un temps de relaxation infini. La relaxation de la contrainte de la couche élastique engendre une déformation simultanée de la couche élastique et de ladite partie au moins liquide de la fondation. Le caractère liquide autorise et favorise la formation de rides plutôt qu'une déformation en flexion. Pour obtenir une structuration d'amplitude supérieure à 30 nm, il est nécessaire que l'épaisseur L rendue liquide soit supérieure ou égale à 20 nm, avantageusement supérieure ou égale à 30 nm, et que la durée pendant laquelle cette couche est liquide soit d'au moins 50 ns pour permettre une relaxation maximale de la couche mince 20. Plus l'épaisseur L de la fondation rendue liquide est importante, plus l'amplitude des rides recherchées peut croître. Il existe toutefois une valeur maximale Lmax de l'épaisseur rendue liquide au-delà de laquelle l'amplitude des rides ne peut plus croitre, cette amplitude maximale étant dictée par la théorie des rides dans le régime de croissance homogène et linéaire de l'amplitude. A titre d'exemple illustratif, on choisit, pour une amplitude de ride recherchée supérieure à 75nm, une épaisseur L typiquement de l'ordre de 50 à 100 nm.

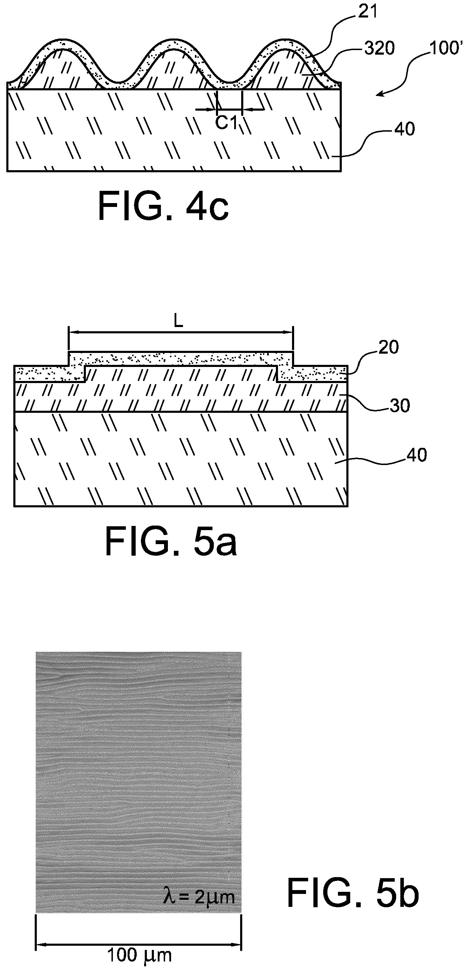

Comme illustré par les figures 2d et 4c, ce procédé de structuration de surface comprend ensuite une solidification de ladite partie au moins 21, 310 de la fondation pour la ramener à l'état solide, ladite solidification formant une structure solide 10', 100' présentant des rides en surface. Ce retour aux conditions initiales (état solide de la fondation) permet de figer les rides formées.

La couche mince élastique, qui se retrouve ridée une fois le retour aux conditions initiales, peut être une électrode, la couche piézoélectrique ou une couche intermédiaire telle qu'une couche en SiO2 par exemple. Différents exemples de réalisation seront présentés par la suite en liaison avec les figures 8 à 14.

L'étape de fusion peut être plus particulièrement réalisée par un apport d'énergie sélectif de manière à ce que l'énergie soit majoritairement absorbée par ladite partie au moins de la fondation d'épaisseur L plutôt que par la couche élastique contrainte et que par le substrat rigide sous-jacent 40 le cas échéant, par exemple avec un ratio d'au moins 100/1, de préférence avec un ratio d'au moins 1000/1.

La couche mince présente de préférence une température de fusion supérieure à la température de fusion de la fondation. De la même manière, le substrat rigide 40 soutenant dans le second mode de réalisation une couche-fondation 30 présente également de préférence une température de fusion supérieure à la température de fusion de la fondation. Alternativement, ou en complément, une couche intermédiaire thermiquement isolante peut être intercalée entre la couche-fondation 30 et le substrat rigide 40 de manière à isoler le substrat rigide 30 des phénomènes thermiques. Ici encore, la couche intermédiaire thermiquement isolante présente de préférence une température de fusion supérieure à la température de fusion de la fondation.

La fondation peut présenter une combinaison de deux matériaux ou plus, de manière à en réduire la température de fusion ou encore d'en améliorer l'absorption de l'apport d'énergie. A titre d'exemple illustratif, un dopage du silicium permet d'en abaisser la température de fusion.

La couche mince peut également présenter une combinaison de deux matériaux ou plus. La combinaison des matériaux peut présenter des propriétés physiques moyennes équivalentes (module d'Young, Poisson, et contrainte) permettant d'ajuster au mieux la structure visée d'après la théorie des rides et/ou peut présenter un comportement moyen vis-à-vis de la source d'énergie de telle sorte que le ratio d'absorption de l'énergie soit au moins de 1/100 idéalement 1/1000 vis-à-vis de la fondation.

La durée de l'étape de fusion est typiquement comprise entre 50ns et 1s, avantageusement entre 50ns et 1ms. On privilégie des durées courtes pour éviter d'élever en température toute la fondation et de trop affecter les propriétés mécaniques de la couche mince. Pour des configurations équivalentes, l'épaisseur de la fondation rendue liquide et la durée à l'état liquide sont les deux paramètres principaux permettant d'ajuster l'amplitude des rides.

La durée de l'étape de refroidissement est également avantageusement contrôlée pour rester inférieure à 1s, avantageusement inférieure à 1ms, et ce afin de préserver les rides pendant le refroidissement. Cette durée peut en particulier être adaptée à la période des rides recherchée. En effet, plus la durée de refroidissement est importante, plus la longueur d'onde des rides est élevée. On peut ainsi freiner le refroidissement, par exemple par un ou plusieurs apports d'énergie pendant cette période, en fonction de la période recherchée.

Suivant la nature des matériaux en jeu, la fusion peut être obtenue en en ayant recours à une source d'énergie laser à une longueur d'onde choisie pour assurer une sélectivité de l'apport d'énergie suivant l'épaisseur et l'absorption des matériaux en jeu, ou encore en ayant recours à une source magnétique d'induction ou une source micro-onde. A titre d'exemple illustratif, on peut utiliser une source laser émettant dans l'ultra-violet, par exemple à une longueur d'onde autour de 300 nm, lorsque la couche mince, par exemple en SiO₂, est transparente aux ultra-violets et que la fondation absorbe au contraire cette lumière, par exemple lorsqu'elle constituée de silicium.

Lorsque la fondation est conductrice électriquement (c'est le cas notamment lorsqu'elle est métallique, par exemple en cuivre) et intercalée entre des matériaux électriquement isolant (couche mince d'un côté, couche intermédiaire et/ou substrat rigide 40 de l'autre), la fusion de ladite au moins une partie de la fondation peut être réalisée par un apport d'énergie thermique exploitant l'effet joule. Lorsque la fondation est intercalée entre des matériaux électriquement conducteurs (couche mince d'un côté, couche intermédiaire et/ou substrat rigide 40 de l'autre) et présente une résistivité supérieure à celle desdits matériaux électriquement conducteurs, la fusion de ladite au moins une partie de la fondation peut être réalisée par un apport d'énergie thermique exploitant un échauffement résistif.

La quantité d'énergie nécessaire pour réaliser la fusion de tout ou partie de la fondation peut être prédéterminée en venant détecter le changement de phase de tout ou partie de la fondation d'une structure étalon, par exemple au moyen d'une mesure de réflectivité, de résistivité, de densité, etc.

Les rides créées sont caractérisées par leur longueur d'onde λ, leur amplitude A et leur orientation O suivant la théorie des rides, et sont principalement liées aux paramètres physiques de la couche mince et de la fondation dans sa phase liquide.

On considère à titre d'exemple illustratif une couche mince en SiO₂ (peau) d'une épaisseur h de 50 nm avec une contrainte en tension de 200 MPa. La fondation est en Si amorphe et fusionnée sur une épaisseur L de 150 nm au contact de la couche mince.

Les calculs présentés ici se placent dans le cadre de la théorie des rides film élastique sur fondation visqueuse/liquide. La fondation est rendue liquide par fusion de sa phase solide à l'aide d'un apport d'énergie focalisé, typiquement laser (UV 308nm, pulse de 150 ns, énergie de 0,8 J.cm-2). La fondation en silicium absorbe la majorité de l'apport d'énergie fourni, la peau en SiO₂ reste transparente à la longueur d'onde de travail.

| Couche mince | | |
|---|---|---|
| Module d'Young | Ep | 80 GPa |
| Poisson | Np | 0.17 |
| Contrainte initiale | Cp | 200 MPa |

| Fondation liquide | | |
|---|---|---|
| Module d'Young | Ef | 120 GPa |
| Module de relaxation | µf | 50 MPa |
| Poisson | Np | 0.22 |

### Période des rides

Lorsque les conditions thermodynamiques sont compatibles avec la formation de rides, la période d'oscillation la plus favorable au système est atteinte instantanément. Dans le cadre de ce procédé de structuration de surface, la période est alors fixée au cours du refroidissement, pendant lequel on considère que la fondation est dans un état visqueux. La période des rides λ est définie par la formule ci-dessous, d'après la publication de R. Huang intitulée « Kinetic wrinkling of an elastic film on a viscoelastic substrate », Journal of Mechanics and Physics of Solids, 2004. $λ = 2 πh {\left[\frac{\left(1-{υ}_{f}\right)}{6 \left(1-{υ}_{p}^{2}\right)}\frac{{E}_{p}}{{μ}_{f}}\right]}^{\frac{1}{3}}$

Le caractère instantané de l'instauration de la période implique que celle-ci va évoluer dans le temps si les paramètres qui la définissent évoluent, notamment µf, module de relaxation visqueux de la fondation. µf est défini par la formule suivante : ${μ}_{f} = \frac{{E}_{f}}{2 \left(1+{ν}_{f}\right)}$

Dans le système dynamique étudié, où la fondation passe de sa phase solide à liquide puis de nouveau solide, la fondation voit son module de relaxation évoluer dramatiquement. D'après Huang 2004, on peut estimer que µf varie sur plus de cinq ordres de grandeur, c'est-à-dire de 50.10⁹ Pa pour sa phase solide à quelques 50.10⁴ Pa pour sa phase visqueuse/liquide. La période λ évolue en conséquence pour se figer lors du retour à la phase solide de la fondation autour d'une valeur correspondant à une "valeur moyenne" de µf estimée à 50.10⁶ Pa. Ainsi, dans ce cas, la période d'oscillation calculée est λ = 1.879µm ce qui correspond à ce qui est observé.

### Amplitude des rides

La croissance de l'amplitude des rides est un phénomène cinétique. Il est d'autant plus rapide que la fondation est dans son état liquide. Ainsi, dans l'exemple étudié où le temps de fusion est de l'ordre 500 ns l'amplitude des oscillations peut atteindre sa valeur maximale décrite dans le cas d'un système peau élastique/fondation liquide.

On peut alors utiliser la formule suivante, d'après la publication de Cerda & Pociavesk, Science, "Stress and Fold Localization in Thin Elastic Membranes", 2008. $A = \frac{\sqrt{2}}{π} λ \sqrt{\frac{Δ}{W}} ,$ avec $Δ = \frac{\left|{σ}_{p}\right| . W}{{E}_{p}}$ représentant la distance de contraction de la peau.

Dans le calcul de la distance Δ, le module d'Young de la peau intervient. Bien que l'on soit dans un cas où l'application de l'énergie est rapide (pulse de 150ns) et que le procédé complet dure moins de 1µs, il est raisonnable de considérer ici que lorsque la fondation est liquide le module d'Young estimée de la peau baisse d'un ordre de grandeur, de 80.10⁹ Pa à 8.10⁹ Pa. On calcule alors une amplitude A de 134 nm soit une hauteur crête à crête de 268 nm.

La figure 3 illustre à ce propos la formation de rides de longueur d'onde d'environ 2 µm et d'amplitude crête à crête de 268 nm.

Cette amplitude crête à crête correspond ainsi à une amplitude crête à crête théorique des rides qui peut être prédéterminée, et être utilisée pour définir l'épaisseur L de la fondation destinée à être fusionnée en sa phase liquide.

Ainsi, dans le premier mode de réalisation où la fondation prend la forme d'un substrat 3, lorsque l'épaisseur L fusionnée est inférieure à une épaisseur prédéterminée correspondant à l'amplitude crête à crête théorique des rides, les rides formées présentent alors une amplitude crête à crête inférieure à l'amplitude crête à crête théorique. Le contrôle de l'épaisseur fusionnée permet ainsi de contrôler l'amplitude des rides formées.

Dans le second mode de réalisation où la fondation prend la forme d'une couche 30 reposant sur un substrat 40, lorsque l'épaisseur fusionnée L est inférieure à l'épaisseur prédéterminée correspondant à l'amplitude crête à crête théorique des rides, la formation des rides s'accompagne comme représenté sur les figures 4b et 4c d'un contact localisé entre la couche mince 21 et le substrat rigide 40 isolant des régions de la fondation 320 entre des zones de contact localisé entre la couche mince 21 et le substrat 40. Là où la théorie prédit une amplitude crête à crête théorique d'environ 268 nm, à partir d'une couche mince en SiO₂ de 50 nm d'épaisseur et de contrainte initiale en tension d'environ 200 MPa et d'une fondation-couche de 150 nm d'épaisseur, il a été observé une amplitude crête à crête limitée à 230 nm.

Ce contact peut être transformé en adhésion lorsque les surfaces de la couche mince et du substrat sont lisses, par exemple avec une rugosité de surface inférieure à 5 nm RMS, ou encore un réalisant un apport d'énergie thermique complémentaire de renforcement de l'adhésion, ou encore via la réitération de l'étape de fusion.

Dans un exemple d'application, les régions isolées de la fondation 30 peuvent en outre être utilisées en tant que masque dur à la gravure lorsque la fondation 30 et le substrat 40 présentent une sélectivité vis-à-vis d'une gravure chimique.

Il est également possible de venir procéder, à l'issue d'un cycle fusion/solidification, à un retrait de la fondation ramenée à l'état solide pour suspendre la couche élastique 21 au-dessus du substrat en dehors des zones de contact adhérent localisé C1.

Le ou les matériaux composant le substrat 40, la fondation 30 et la couche élastique 20 peuvent en particulier être choisis de telle manière que la fondation 30 présente par rapport à la couche mince 20 et au substrat 40 une forte sélectivité vis-à-vis d'une gravure, typiquement une sélectivité supérieure à 1000/1. Le retrait de la fondation est alors réalisé par gravure du matériau solide 320 de fondation reposant sous la couche mince 21 pour former une structure constituée du substrat 40 et de la couche mince suspendue au-dessus du substrat en dehors des zones de contact adhérent localisées.

On relèvera que le procédé peut comprendre avant retrait de la fondation, un retrait de la couche élastique (par exemple par gravure sélective vis-à-vis de la fondation et du substrat) puis un dépôt d'une nouvelle couche sur la fondation et le substrat. Cette nouvelle couche prend également la forme d'une couche ondulée conformément aux rides et en contact localisé avec le substrat. Cette nouvelle couche ondulée formera la couche localement suspendue après retrait de la fondation.

En variante, une ou plusieurs couches peuvent être déposées sur la couche ondulée, avant ou après retrait de la fondation, et notamment la ou les couches formant électrodes ainsi que la couche piézoélectrique.

D'une manière générale, la couche ondulée (couche mince, ou nouvelle couche déposée) peut être une structure multi-couches, par exemple une structure comprenant une couche en matériau piézoélectrique prise en sandwich entre deux couches métalliques. Et après retrait de la fondation, la couche ondulée reposant localement sur le substrat peut être recouverte d'une ou plusieurs couches, par exemple d'encapsulation.

### Orientation des rides

S'agissant de l'orientation O des rides, une orientation privilégiée de structuration peut être définie en disposant d'une couche élastique dont la contrainte présente initialement une rupture de continuité dans le plan de la couche, de préférence des ruptures de contrainte dans une seule direction du plan espacées d'une longueur inférieure à 2000 fois l'épaisseur h de la couche. On a représenté sur la figure 5a un bas-relief introduisant de telles ruptures de contrainte, ici espacées de 100 µm, avec une couche-fondation 30 présentant une épaisseur de 150 nm au niveau du bas-relief et de 70 nm ailleurs. La figure 5b illustre la formation de rides orientées de manière quasi-parallèle à partir d'une couche mince contrainte 20 en SiO₂ de 50 nm d'épaisseur et présentant une contrainte initiale en tension de 100 MPa, d'une couche-fondation 30 en Si présentant le bas-relief de la figure 5a et reposant sur un substrat 40 de Si comportant en surface une couche intermédiaire thermiquement isolante en SiO₂.

Dans un mode de réalisation, le procédé peut comprendre une étape initiale de création de motifs en surface de la couche élastique et/ou de la fondation pour induire ladite rupture de continuité de contrainte. Cette création de motifs est par exemple réalisée au moyen d'un trait de laser.

Dans un mode de réalisation possible, la couche mince et la fondation sont choisies de manière à présenter une sélectivité vis-à-vis d'une gravure, par exemple une gravure sèche humide ce qui permet de réaliser un retrait de la peau ou de la fondation. Dans la mesure où, à l'issue de l'étape de solidification, la structure formée 10', 100' reste figée, un tel retrait ne conduit pas à la disparition de la structuration de surface ridée.

Dans un exemple d'application, lorsque la fondation prend la forme d'une couche 30 reposant sur un substrat rigide 40, la fondation et le substrat peuvent être choisis de manière à présenter une sélectivité faible, de préférence une sélectivité nulle, vis-à-vis d'une gravure, par exemple une gravure sèche humide. De telle manière, après éventuel retrait de la couche mince lorsqu'elle ne présente pas elle aussi une sélectivité faible vis-à-vis de la gravure retenue, la structuration de surface est transférée de la fondation au substrat.

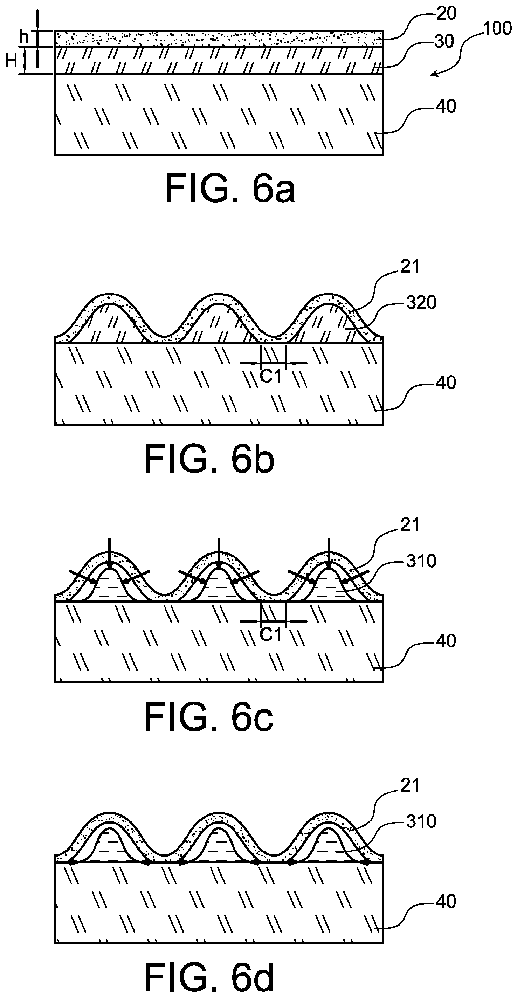

Une variante du mode de réalisation où la fondation prend la forme d'une couche 30 reposant sur un substrat 40, et applicable lorsque l'épaisseur fusionnée L est inférieure à l'épaisseur prédéterminée correspondant à l'amplitude crête à crête théorique des rides, est détaillée ci-après en référence aux figures 6a-6e.

La figure 6a représente la structure initiale 100 constituée du substrat 40, de la fondation 30 et de la couche mince élastique contrainte 20. La figure 6b représente la structure obtenue suite aux étapes de fusion et de solidification décrites précédemment permettant d'aboutir à la formation de rides figées et à un contact adhérent localisé de la couche mince ridée 21 avec le substrat 40 isolant des régions de la fondation solide ridée. Une zone de contact adhérent couche mince / substrat forme un intervalle séparant deux régions adjacentes de la fondation qui s'étend sur une distance C1.

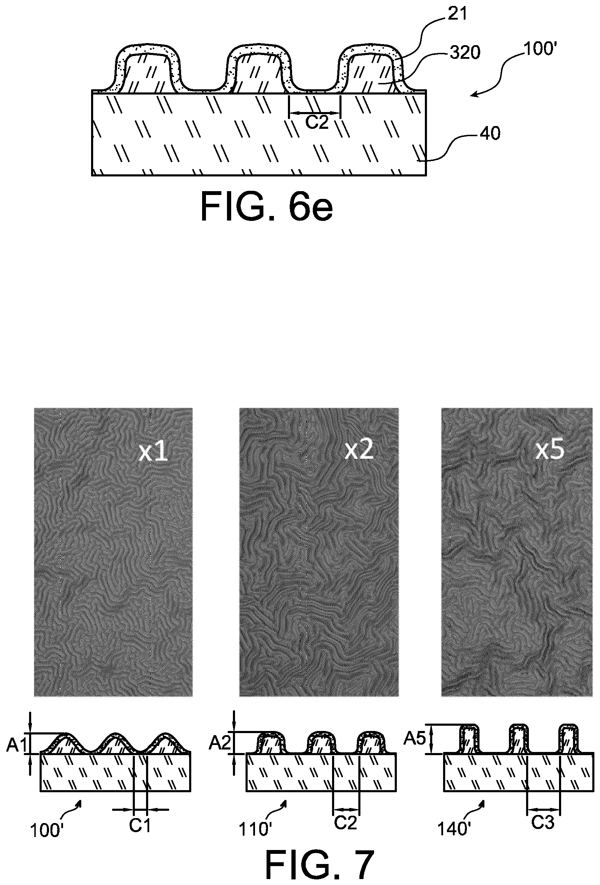

Dans le cadre de cette variante, on peut venir réitérer les étapes de fusion et de solidification. En prenant l'exemple d'une fondation en un matériau qui présente la propriété de se contracter volumiquement lors du passage de son état solide à son état liquide (comme c'est le cas par exemple des matériaux suivants : Si, Ga, Ge, Pu, Sb, α-ZrW₂O₈, C₂N₂Zn, H₂O), on vient dans le cadre de cette variante réitérer les étapes de fusion et de solidification de sorte que le moindre volume en phase liquide de la fondation 310, illustré sur la figure 6c, s'accompagne d'un contact de la couche mince 21 avec le substrat 40 sur une distance plus importante ce qui favorise l'adhésion comme représenté sur la figure 6d. Il en résulte, après solidification, la structure 110' représentée sur la figure 6e pour laquelle l'intervalle C2 entre les régions isolées de la fondation est accentué et l'amplitude des rides est augmentée.

Comme représenté sur la figure 7, il est possible de réitérer à de multiples reprises les étapes de fusion et de solidification, tant que la couche mince résiste à la déformation. Les travaux d'adhésion de la couche mince et du substrat affinent les régions isolées de fondation dans les structures formées 100', 110', 140' (après respectivement 1, 2 et 5 séquences fusion/solidification de gauche à droite sur la figure 7) qui voient leur amplitude A1, A2, A5 progressivement augmenter tandis que l'intervalle C1, C2, C5 séparant les régions isolées augmente. Les régions isolées présentent l'avantage d'être lisses car issues d'une phase liquide et présentent ainsi moins de défauts par comparaison à des procédés lithographiques suivis de gravure.

On veille dans le cadre de cette variante à limiter le nombre de réitérations des étapes de fusion et de solidification afin que la couche mince résiste aux contraintes de déformation. Et on peut procéder au retrait de la fondation suite à plusieurs réitérations du des étapes de fusion et de solidification.

La déformation de la peau présentant une limite, lors d'une contraction volumique obtenue lors d'une réitération de l'étape de fusion, le liquide se trouve encore plus confiné et le retour à l'état solide conduit à une élévation trop importante de la pression. Ceci entraîne la rupture de la couche mince dans la zone où le stress est maximal, à savoir au maximum d'amplitude des rides. Cette rupture s'accompagne de l'éruption du liquide en fusion issue de la fondation. Ce liquide peut se déverser le long de la peau. Si les conditions sont propices, et notamment si le matériau en fusion présente une faible mouillabilité vis-à-vis du matériau de surface de la peau (correspondant typiquement à un angle de goutte supérieure à 80°), une bille nanométrique de matériau peut se former au sommet du cratère.

Différents exemples de réalisation d'un capteur sont présentés ci-après par la suite en liaison avec les figures 8 à 14.

Comme représenté sur les figures 8-11 et 14, le substrat 1 peut être recouvert d'une couche formant électrode inférieure 3a.

La couche piézoélectrique 2 peut être formée directement sur l'électrode inférieure 3a comme représenté sur la figure 8.

Dans le cadre d'une « fabrication polymère », le capteur de la figure 8 peut être réalisé au moyen d'une couche piézoélectrique polymère en tant que fondation, et d'une couche métallique en tant que peau, cette couche métallique étant amenée à servir d'électrode supérieure 4 du capteur.

Comme représenté sur la figure 9, le capteur peut en outre comprendre une couche intermédiaire inférieure 5 interposée entre l'électrode inférieure 3a et la couche piézoélectrique 2, la couche intermédiaire inférieure 5 présentant des ondulations de surface identiques à celles de la couche piézoélectrique.

Dans le cadre d'une « fabrication polymère », le capteur de la figure 9 peut être réalisé au moyen d'une couche polymère formant la couche intermédiaire inférieure 5 en tant que fondation, et de la couche piézoélectrique 2 en tant que peau. La couche piézoélectrique 2 est ensuite revêtue d'une couche métallique amenée à servir d'électrode supérieure 4. La peau peut également former un bicouche associant la couche piézoélectrique 2 et la couche métallique formant l'électrode supérieure 4.

Dans le cadre d'une « fabrication solide », le capteur de la figure 8 peut être réalisé au moyen de la couche intermédiaire inférieure 5 en tant que fondation, et de la couche piézoélectrique 2 en tant que peau. La couche piézoélectrique 2 est ensuite revêtue d'une couche métallique amenée à servir d'électrode supérieure 4. La peau peut également former un bicouche associant la couche piézoélectrique 2 et la couche métallique formant l'électrode supérieure 4. Dans une variante, la peau peut être retirée après la formation de rides en surface de la couche intermédiaire inférieure 5, avant de réaliser un dépôt conforme de l'empilement constitué par couche piézoélectrique 2 et de la couche métallique formant l'électrode supérieure 4.

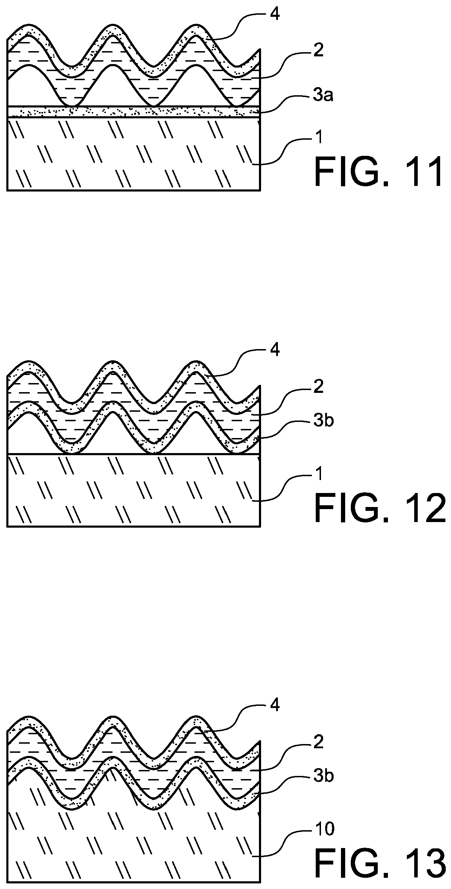

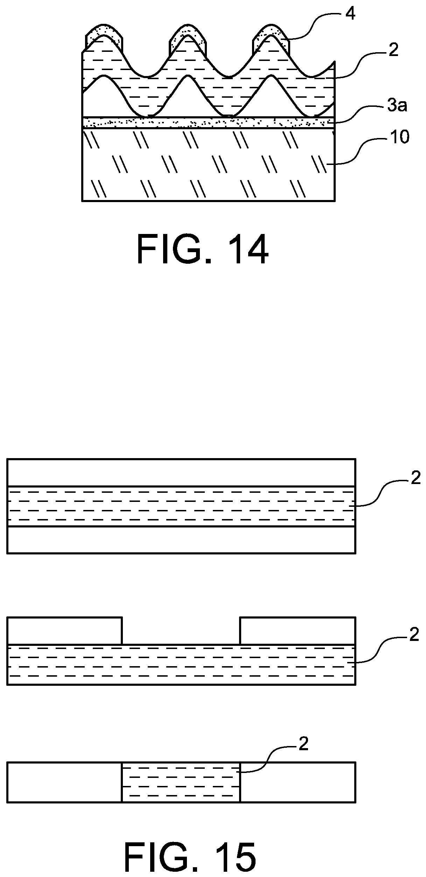

Comme représenté sur les figures 11 et 14, la couche piézoélectrique 2 peut également être une couche ondulée suspendue au-dessus du substrat 1 en dehors de zones de contact localisé avec l'électrode inférieure 3a qui repose sur le substrat. Une telle structure peut être obtenue par une « fabrication solide » dans laquelle la couche piézoélectrique 2, et éventuellement la couche métallique 4 formant électrode supérieure, forment la peau, ou sont déposées de manière conforme sur la fondation suite au retrait de la peau. On se place ici dans le cas de figure où par le choix de l'épaisseur de la fondation la formation des rides s'accompagne d'un contact localisé de la peau avec le substrat (en l'occurrence avec l'électrode inférieure 3a, éventuellement avec plusieurs cycles fusion/solidification de la fondation), et où on procède au final à un retrait de la fondation pour suspendre la couche piézoélectrique ondulée 2 au-dessus du substrat 1. Ce retrait peut être facilité du fait de l'agencement des rides. On peut ainsi, pour faciliter l'accès de la solution de gravure, privilégier des rides agencées sous forme de lignes parallèles pour venir ensuite creuser par gravure au moins une tranchée perpendiculaire aux rides.

On a vu précédemment que le substrat pouvait être recouvert de l'électrode inférieure. Dans une variante illustrée par la figure 10, le substrat 1 est recouvert d'une couche intermédiaire inférieure 5 présentant des ondulations de surface identiques à celles de la couche piézoélectrique. Le capteur est alors fabriqué de manière similaire à celui de la figure 9, l'électrode inférieure 3b étant formée non pas en surface du substrat mais interposée entre la couche intermédiaire inférieure 5 et la couche piézoélectrique 2.

Selon l'invention, dans une autre variante représentée sur la figure 12, l'électrode inférieure 3b prend la forme d'une couche ondulée suspendue au-dessus du substrat 1 en dehors de zones de contact localisé avec le substrat. Le procédé de fabrication est similaire à celui du capteur de la figure 11 avec retrait de la fondation dans le cadre d'une « fabrication solide », la seule différence tenant à la présence de l'électrode inférieure 3b en surface de la fondation avant son retrait plutôt qu'en surface du substrat.

Les capteurs selon les figures 11, 12 et 14 avec retrait de la fondation sont ceux qui assurent une capacité de déformation maximale de la couche piézoélectrique du fait de la seule présence d'air en dessous des rides, et de là une précision maximale. Seul le capteur selon la figure 12 est représentatif de l'invention.

Dans un autre exemple de réalisation du capteur ne faisant pas partie de l'invention illustré par la figure 13, le substrat 10 présente lui-même des ondulations de surface identiques à celles de la couche piézoélectrique 2.

Dans le cadre d'une « fabrication polymère », le capteur de la figure 10 peut être réalisé en ayant recours à un substrat 10 en un matériau polymère en tant que fondation, par exemple un substrat en Plexiglas (nom déposé), et d'une couche métallique formant électrode inférieure 2b en tant que peau. L'électrode inférieure 3b peut ensuite être revêtue de la couche piézoélectrique 2 et d'une couche métallique amenée à servir d'électrode supérieure 4. La peau peut également former un bicouche associant l'électrode inférieure 3b et la couche piézoélectrique 2, ou un tricouche en y associant également la couche métallique formant l'électrode supérieure 4.

Dans le cadre d'une « fabrication solide », le capteur de la figure 13 peut être réalisé en utilisant une couche superficielle du substrat en tant que fondation, et l'électrode inférieure 3b (avec éventuellement la couche piézoélectrique 2, ainsi éventuellement que l'électrode supérieure) en tant que peau. La peau peut alternativement être retirée après obtention du substrat ridée, avant de venir déposer l'empilement électrode inférieure-couche piézoélectrique-électrode supérieure.

Dans un exemple de réalisation non représenté, la couche formant électrode supérieure 4 peut ne pas être formée directement en surface de la couche piézoélectrique 2, une couche intermédiaire supérieure étant interposée entre l'électrode supérieure et la couche piézoélectrique.

Comme représenté sur la figure 14, l'électrode supérieure peut comprendre une pluralité de régions spatialement séparées les unes des autres de manière à permettre la formation de plusieurs zones de détection individualisées. Le capteur peut de la sorte fournir une information de localisation, par exemple en y intégrant un matriçage des zones de détection. La couche métallique formant la couche supérieure peut être gravée en conséquence, un masque venant recouvrir les régions de l'électrode supérieure à conserver. Une région de l'électrode supérieure couvre typiquement une pluralité de rides de la couche piézoélectrique, et peut venir recourir le sommet d'une seule ride comme représenté sur la figure 14.

Les rides de la couche piézoélectrique peuvent être orientées de manière labyrinthique, rectiligne, ou encore de manière à former une série d'anneaux concentriques. Dans un mode de réalisation possible, la couche piézoélectrique présente plusieurs régions distinctes, l'orientation des rides dans une région étant différente de l'orientation des rides dans une autre région. A titre d'exemple illustratif, on peut concevoir des rides orientées rectilignement de telle manière que les rides d'une région soient perpendiculaires à celles d'une autre région.

Alternativement, on peut prévoir d'associer plusieurs capteurs élémentaires selon l'invention, chaque capteur élémentaire présentant un seul type d'orientation de rides, de telle manière à disposer d'un capteur composé de plusieurs zones de détection présentant différentes orientations. A titre d'exemple illustratif, on peut prévoir des capteurs élémentaires à orientation rectiligne des rides, et les associer de telle manière à alterner des zones de détection dont les rides sont orientées perpendiculairement entre elles d'une zone de détection à l'autre.

Dans les exemples de réalisation précédemment décrits, la couche piézoélectrique et les électrodes sont agencées de manière à former un sandwich électrode inférieure-couche piézoélectrique-électrode supérieur sous la forme d'un empilement vertical. En référence à la figure 15, l'invention n'est toutefois pas limitée à un tel agencement (en haut sur la figure 15) mais s'étend également à un agencement selon lequel les électrodes sont toutes deux disposées du même côté de la couche piézoélectrique (par exemple les deux au-dessus de la couche piézoélectrique, au milieu sur la figure 15), ou encore à un agencement selon lequel la couche piézoélectrique est prise en sandwich latéralement par les électrodes (en bas sur la figure 15) en venant les former de part et d'autre de la couche piézoélectrique.

Grâce à l'invention on peut obtenir des structures « ridées » dont les dimensions varient entre quelques µm² et quelques cm². Ces structures peuvent ensuite être aboutées pour former des structures de plus grandes tailles encore.

Il est possible également de mettre en œuvre l'invention sur des surfaces non planes (sphériques, tubulaires...) et ainsi obtenir des capteurs de géométrie très diverses.

## Revendications

1. Capteur sensible à la pression comprenant un substrat (1, 10) et une couche piézoélectrique (2) supportée par le substrat qui présente des ondulations de surface sous la forme de rides sur lesquelles la pression est exercée lors de l'utilisation du capteur,
dans lequel la couche piézoélectrique (2) est en un matériau solide choisi parmi AIN, PZT, ZnO, LiNbO3, LiTaO3, KNbO3, le quartz, SrTiO3, BaTiO3 et les langasites, et
dans lequel le capteur comprend en outre une couche ondulée (21) suspendue au-dessus du substrat en dehors de zones de contact adhérent localisées avec le substrat, ladite couches ondulée comprenant la couche piézoélectrique et deux électrodes, les électrodes étant disposées relativement à la couche piézoélectrique (2) avec une disposition sélectionnée parmi :
- latéralement de part et d'autre de la couche piézoélectrique (2),
- verticalement de part et d'autre de la couche piézoélectrique (2),
- sur un même côté de la couche piézoélectrique (2).

2. Capteur selon la revendication 1, dans lequel la disposition est verticalement de part et d'autre de la couche piézoélectrique (2), le capteur comprenant une électrode inférieure (3b) sous la forme d'une couche ondulée suspendue au-dessus du substrat (1) en dehors de zones de contact adhérent localisé avec le substrat.

3. Capteur selon la revendication 2, comprenant une électrode supérieure (4) formée de manière conforme en surface de la couche piézoélectrique (2).

4. Capteur selon l'une des revendications 2 à 3, comprenant une électrode supérieure et une couche intermédiaire supérieure entre l'électrode supérieure et la couche piézoélectrique.

5. Capteur selon l'une des revendications 3 et 4, dans lequel l'électrode supérieure comprend une pluralité de régions spatialement séparées les unes des autres.

6. Capteur selon l'une des revendications 1 à 5, dans lequel les rides de la couche piézoélectrique sont orientées de manière rectiligne.

7. Capteur selon l'une des revendications 1 à 6, dans lequel les rides de la couche piézoélectrique sont orientées de manière à former une série d'anneaux concentriques.

8. Capteur selon l'une quelconque des revendications 1 à 7, dans lequel la couche ondulée est recouverte d'une ou plusieurs couches d'encapsulation.

9. Ensemble de capteurs comprenant une pluralité de capteurs élémentaires, chaque capteur élémentaire étant un capteur selon l'une quelconque des revendications 1 à 8, chaque capteur élémentaire présentant un seul type d' orientation de rides de sa couche ondulée, au moins deux capteurs élémentaires présentant une orientation de rides différentes l'un de l'autre.

10. Ensemble de capteurs comprenant une pluralité de capteurs élémentaires selon la revendication 9, dans lequel les capteurs élémentaires présentent une orientation de rides rectiligne et sont associés de manière à alterner entre deux orientations de rides perpendiculaires l'une de l'autre.

## Patentansprüche

1. Druckempfindlicher Sensor, der ein Substrat (1, 10) und eine von dem Substrat getragene piezoelektrische Schicht (2) umfasst, die Oberflächenwelligkeiten in Form von Falten aufweist, auf die bei der Verwendung des Sensors Druck ausgeübt wird,
wobei die piezoelektrische Schicht (2) aus einem festen Material besteht, das aus AIN, PZT, ZnO, LiNbO3, LiTaO3, KNbO3, Quarz, SrTiO3, BaTiO3 und den Langasiten ausgewählt ist, und
wobei der Sensor ferner eine gewellte Schicht (21) umfasst, die über dem Substrat außerhalb von mit dem Substrat lokalisierten Haftkontaktbereichen aufgehängt ist, wobei
die gewellte Schicht die piezoelektrische Schicht und zwei Elektroden umfasst, wobei die Elektroden relativ zur piezoelektrischen Schicht (2) in einer Anordnung angeordnet sind, die aus Folgendem ausgewählt ist:
- seitlich auf beiden Seiten der piezoelektrischen Schicht (2),
- vertikal auf beiden Seiten der piezoelektrischen Schicht (2),
- auf derselben Seite der piezoelektrischen Schicht (2).

2. Sensor nach Anspruch 1, wobei die Anordnung vertikal auf beiden Seiten der piezoelektrischen Schicht (2) angeordnet ist, wobei der Sensor eine untere Elektrode (3b) in Form einer gewellten Schicht umfasst, die über dem Substrat (1) außerhalb von mit dem Substrat lokalisierten Haftkontaktbereichen aufgehängt ist.

3. Sensor nach Anspruch 2, umfassend eine obere Elektrode (4), die oberflächenkonform auf der piezoelektrischen Schicht (2) ausgebildet ist.

4. Sensor nach einem der Ansprüche 2 bis 3, umfassend eine obere Elektrode und eine obere Zwischenschicht zwischen der oberen Elektrode und der piezoelektrischen Schicht.

5. Sensor nach einem der Ansprüche 3 und 4, wobei die obere Elektrode eine Vielzahl von voneinander räumlich getrennten Bereichen umfasst.

6. Sensor nach einem der Ansprüche 1 bis 5, wobei die Falten der piezoelektrischen Schicht geradlinig ausgerichtet sind.

7. Sensor nach einem der Ansprüche 1 bis 6, wobei die Falten der piezoelektrischen Schicht so ausgerichtet sind, dass sie eine Reihe konzentrischer Ringe bilden.

8. Sensor nach einem der Ansprüche 1 bis 7, wobei die gewellte Schicht mit einer oder mehreren Kapselungsschichten bedeckt ist.

9. Sensorbaugruppe, die eine Vielzahl von Elementarsensoren umfasst, wobei jeder Elementarsensor ein Sensor nach einem der Ansprüche 1 bis 8 ist, wobei jeder Elementarsensor eine einzige Art von Faltenausrichtung seiner gewellten Schicht aufweist, wobei mindestens zwei Elementarsensoren eine voneinander unterschiedliche Faltenausrichtung aufweisen.

10. Sensorbaugruppe, umfassend eine Vielzahl von Elementarsensoren nach Anspruch 9, wobei die Elementarsensoren eine geradlinige Faltenausrichtung aufweisen und so verbunden sind, dass sie zwischen zwei zueinander senkrechten Faltenausrichtungen abwechseln.

## Claims

1. Pressure sensitive sensor comprising a substrate (1, 10) and a piezoelectric layer (2) supported by the substrate which has surface undulations in the form of wrinkles on which pressure is exerted during use of the sensor, wherein the piezoelectric layer (2) is made of a solid material selected from AIN, PZT, ZnO, LiNbO3, LiTaO3, KNbO3, quartz, SrTiO3, BaTiO3 and langasites, and wherein the piezoelectric layer (2) is a corrugated layer locally suspended above the substrate (1) outside of areas of localized adherent contact with the substrate, said corrugated layer comprising a piezoelectric layer and two electrodes, the electrodes being arranged relatively to the piezoelectric layer (2), with an arrangement selected between:
- laterally on either side of the piezoelectric layer (2),
- vertically on either side of the piezoelectric layer (2),
- on the same side of the piezo layer (2).

2. The sensor according to claim 1, wherein the arrangement is vertically on either side of the piezoelectric layer (2), the sensor comprising a lower electrode (3b) as an undulated layer suspended above the substrate (1) outside zones of localized adherent contact with the substrate.

3. The sensor according to claim 2, comprising an upper electrode (4) conformally formed at the surface of the piezoelectric layer (2).

4. The sensor according to claims 2 or 3, comprising an upper electrode and an upper intermediate layer between the upper electrode and the piezoelectric layer.

5. The sensor according to claims 3 or 4, wherein the upper electrode comprises plural regions that are spatially separated from one another.

6. Sensor according to any one of claims 1 to 5, wherein the wrinkles of the piezoelectric layer are oriented in a rectilinear manner.

7. Sensor according to any one of claims 1 to 6, wherein the wrinkles of the piezoelectric layer are oriented so as to form a series of concentric rings.

8. Sensor according to any one of claims 1 to 7, The corrugated layer is covered with one or more encapsulation layers.

9. Sensor array comprising a plurality of individual sensors, each individual sensor being a sensor according to any one of claims 1 to 8, each sensor having a single type of wrinkle orientation in its corrugated layer, at least two elementary sensors having different wrinkle orientations one from another.

10. Sensor array comprising a plurality of individual sensors according to claim 9, wherein the elementary sensors have a rectilinear wrinkle orientation and are associated so that they alternate between two directions of wrinkles that are perpendicular to each other.
